# EUROPEAN PATENT APPLICATION

(11) **EP 1 592 052 A1**
(43) Date of publication of application: **02.11.2005**
(21) Application number: 04706798.8
(22) Date of filing: 30.01.2004
(51) Int. Cl.: H01L 21/3213, H01L 21/285, H01L 21/28, H01L 21/336, H01L 21/3065, B05D 3/04, H05K 3/10, G09F 9/30

(54) **METHOD FOR MANUFACTURING DISPLAY**

(30) Priority: 05.02.2003 JP 2003028132; 05.02.2003 JP 2003028230
(71) Applicant: SEMICONDUCTOR ENERGY LABORATORY CO., LTD., Asugi-shi, Kanagawa Ken 243-0036 (JP)
(72) Inventor: YAMAZAKI, Sh., Semiconductor Energy Lab., Co. Ltd, Kanagawa 243-0036 (JP)
(74) Representative: Grünecker, Kinkeldey, Stockmair & Schwanhäusser Anwaltssozietät
(86) International application number: PCT/JP2004/000895
(87) International publication number: WO 2004/070819

(57) **Abstract**

The present invention proposes a manufacturing method of a display device that accomplishes a lower production cost of a display device by using means for partially forming a resist film and means for partially forming a film and etching or ashing by plasma treatment at or near the atmospheric pressure.

The manufacturing method of the display device according to the invention is **characterized by** including a step of partially forming a conductor film at or near the atmospheric pressure and forming wirings. Here, the wirings include all kinds of wirings such as connection wirings for sending signals from external input terminals to a pixel portion, wirings for connecting thin film transistors (TFT) to pixel electrodes, and so forth, besides wirings operating as gate wirings and source wirings at the pixel portion of an active matrix type display device.

## Description

### Technical Field

This invention relates to a manufacturing method of a display device. More particularly, the invention relates to a manufacturing method of a display device that makes contrivances to a manufacturing method of transistors for driving a display device.

### Background Art

Scales of display devices such as a liquid crystal display device and an electroluminescence display device have become greater and greater. However, a problem develops in that a production yield gets deteriorated and a production cost becomes higher with the increase in the scales of the display devices.

A TFT array substrate (TFT: Thin Film Transistors) that has been conventionally used for driving the display device is fabricated by repeating the steps of forming a film on an entire surface of a substrate, forming a resist mask by photolithography and etching and removing unnecessary portions of the film formed by use of this mask (refer to Patent Reference 1, for example)

However, regions on the TFT array substrate in which the TFT is formed are very limited and almost all the resulting film is etched away. In other words, almost all of the film is removed as a waste. Since a resist material is applied to the entire surface of the substrate by a spin coat method in lithography, almost all of the resist material added drop-wise scatters away in vain from the treated substrate. Such an unnecessary material results in the factor that hinders the reduction of the raw material cost.

A large scale manufacturing apparatus for producing a large scale display device invites the increase in a cost of equipment with the increase in the capacity of a treating chamber, for example a vacuum apparatus having a greater exhaust capacity. Furthermore, the time before reaching a predetermined degree of vacuum gets elongated to increase a processing time.

Therefore, development of a manufacturing method of a display device that can reduce the raw material cost, the equipment cost, the process time and the number of process steps as much as possible and can lower the production cost has been required.

Patent Reference 1: JP-A-6-202153

### Disclosure of the Invention

### (Problem to be solved by the Invention)

In view of the problems described above, the present invention proposes a manufacturing method of a display device that accomplishes a lower manufacturing cost of a display device by using means for partially forming a resist film and means for forming a film and etching or ashing by plasma treatment at or vicinity of the atmospheric pressure.

### (Means for Solving the Problems)

A manufacturing method of a display device according to the present invention is characterized by including a step of partially forming a conductor film at or near the atmospheric pressure and forming a wiring.

The formation of the partial conductor film at or near the atmospheric pressure may be carried out by using plasma treatment means having electrodes for generating plasma.

Here, the term "wiring" includes all kinds of wirings such as connection wirings for sending signals from external input terminals to a pixel portion, wirings for connecting thin film transistors (TFT) to pixel electrodes, and so forth, besides wirings operating as gate wirings and source wirings at the pixel portion of an active matrix type display device.

The plasma treatment means is the one that can generate plasma at or near the atmospheric pressure (5 to 800 Torr) and includes at least one set of electrodes for generating plasma.

In the invention, not only the conductor film but also a resist film, an insulating film, and so forth, may be partially formed. Besides the formation of the films, etching and ashing of the film may be partially carried out.

Another manufacturing method of a display device according to the invention is characterized in that a conductor film partially formed at or near the atmospheric pressure by using plasma treatment means having electrodes for generating plasma is etched by using a mask such as a resist mask and is further processed into a more precise shape.

When the resist mask is formed, the resist film may be partially formed by using liquid droplet jetting means having a plurality of liquid droplet jetting ports arranged or liquid discharge means having a plurality of liquid discharge ports. The resist film partially formed in this way may be as such used as the resist mask or may be further processed into a more precise form by photolithography and may then be used as the resist mask. When the resist film is partially formed in this way, the use amount of the resist film can be much more reduced than when the resist film is formed by use of a spin coat method.

Etching may be carried out by partially blowing a reactive gas to a treated article at or near the atmospheric pressure by using plasma treatment means having electrodes for generating plasma. When the etching treatment is carried out in this way at or near the atmospheric pressure, the time necessary for achieving a vacuum state inside an etching treatment chamber and equipment of a vacuum system can be simplified. When the reactive gas is blown partially, the use amount of the reactive gas necessary for the etching step can be reduced.

The resist mask that becomes unnecessary after etching may be removed by partially blowing the reactive gas to the treated article at or near the atmospheric pressure by using plasma treatment means having electrodes for generating plasma.

Another invention is a manufacturing method of a display device comprising the steps of partially blowing a reactive gas to a surface of an insulating film covering thin film transistors at or near the atmospheric pressure by use of plasma treatment means having electrodes for generating plasma to etch a part of the insulating film, and forming contact holes penetrating through the insulating film.

The plasma treatment means is the one that can generate plasma at or near the atmospheric pressure (5 to 800 Torr) and has at least one electrode for generating plasma.

When the insulating film is etched, etching may be carried out by using a resist mask. Consequently, the contact holes having a more precise shape can be formed. When the resist mask is formed, as mentioned above, the resist film may be partially formed by using liquid droplet jetting means having a plurality of droplet jetting ports arranged or liquid discharging means having a plurality of liquid discharging ports arranged. The resist film partially formed in this way may be used as the resist mask in the as-formed shape or as the resist mask after the resist film is processed into a more precise shape by photolithography, or the like.

Moreover, the resist mask that becomes unnecessary after etching may be removed by partially blowing the reactive gas to the treated article at or near the atmospheric pressure by using the plasma treatment means having electrodes for generating plasma as described above.

### (Effect of the Invention)

The present invention can reduce the use amount of the raw materials used in the manufacturing steps and the vacuum treatment step and can produce a display device at a reduced cost of production. The invention can accomplish a lower price in electronic appliances having these display devices mounted thereto.

### Brief Description of the Drawings

Figs. 1(A) to 1(C) are views for explaining a plasma treatment in the invention.
Figs. 2(A) and 2(B) are views for explaining a resist film formation method in the invention.
Fig. 3 is a view for explaining a resist film formation method in the invention.
Figs. 4(A) to 4(C) are views for explaining a resist film formation method in the invention.
Figs. 5(A) and 5(B) are views for explaining a resist film formation method in the invention.
Figs. 6(A) and 6(B) are views for explaining a plasma treatment apparatus used in the invention.
Figs. 7(A) to 7(E) are views for explaining a plasma treatment apparatus used in the invention.
Figs. 8(A) to 8(C) are views for explaining a contact hole formation method used in the invention.
Figs. 9(A) to 9(E) are views for explaining a manufacturing method of a display device in the invention.
Figs. 10(A) to 10(F) are views for explaining a manufacturing method of a display device in the invention.
Figs. 11(A) to 11(C) are views for explaining a manufacturing method of a display device in the invention.
Figs. 12(A) to 12(C) are views for explaining a manufacturing method of a display device in the invention.
Figs. 13(A) to 13(C) are views for explaining a manufacturing method of a display device in the invention.
Figs. 14(A) and 14(B) are views for explaining a manufacturing method of a display device in the invention.
Fig. 15 is a view for explaining an electronic appliance to which the invention is applied.
Fig. 16 is a view for explaining a resist film formation method in the invention.
Figs. 17(A) and 17(B) are views for explaining a plasma treatment apparatus used in the invention.
Figs. 18(A) to 18(E) are views for explaining a manufacturing method of a display device in the invention.
Figs. 19(A) to 19(E) are views for explaining a manufacturing method of a display device in the invention.
Figs. 20(A) to 20(C) are views for explaining a manufacturing method of a display device in the invention.
Figs. 21(A) to 21(C) are views for explaining a manufacturing method of a display device in the invention.
Figs. 22(A) and 22(B) are views for explaining a manufacturing method of a display device in the invention.
Figs. 23(A) to 23(C) are views for explaining a plasma treatment in the invention.
Fig. 24 is a view for explaining plasma treatment means used in the invention.
Fig. 25 is a view for explaining a plasma treatment method in the invention.

### Best Mode for Carrying out the Invention

Hereinafter, embodiment of the invention will be explained with reference to drawings. However, the invention can be executed in a large number of different embodiments and those skilled in the art could readily understand that forms and details of the invention could be modified in various ways without departing from the gist and scope of the invention. Therefore, the invention should not be interpreted while being limited to the content of the description of the embodiments.

### (Embodiment 1)

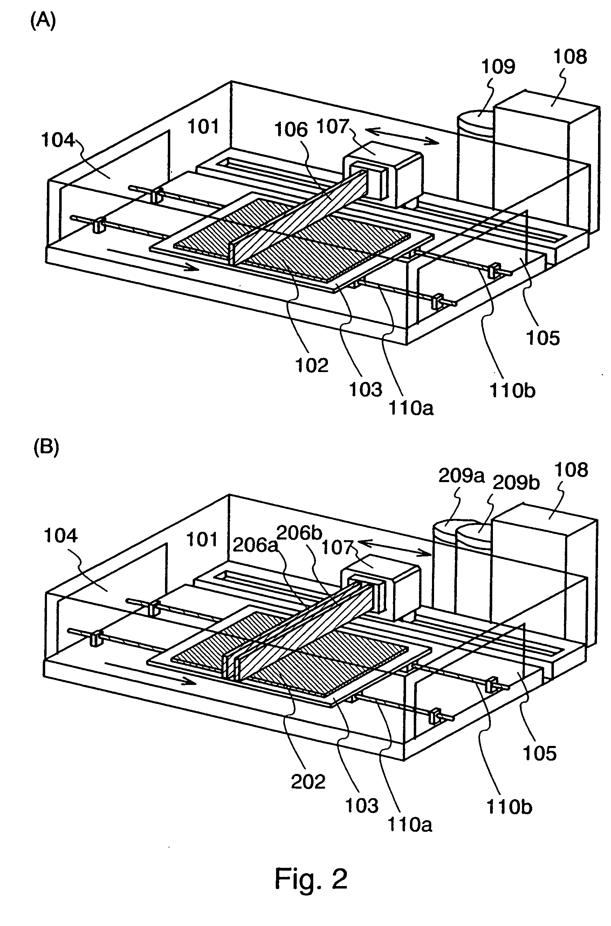

In this embodiment, a method of partially forming a resist mask by use of an apparatus shown in Figs. 2(A) and 2(B) will be explained.

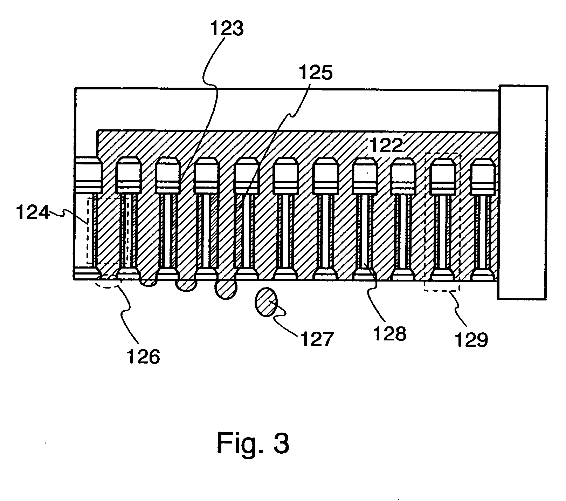

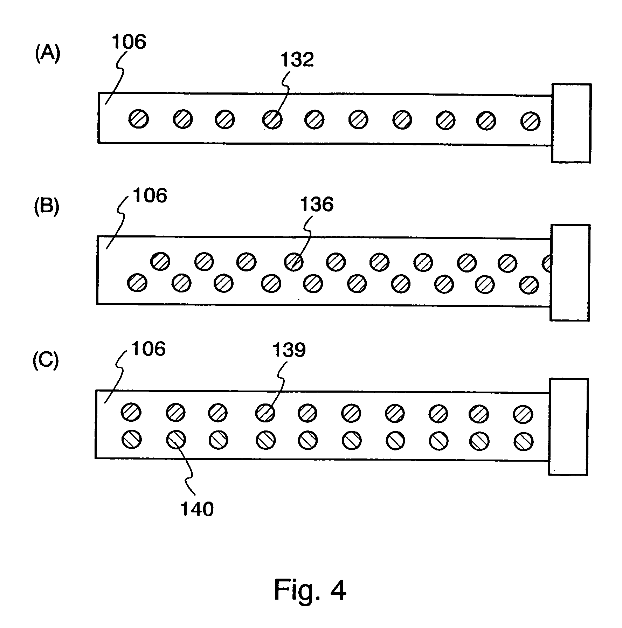

Initially, the apparatus shown in Fig. 2(A) will be explained. Fig. 2(A) shows a structural example of a liquid droplet jetting apparatus. Fig. 3 and Figs. 4 (A) to 4(C) show a liquid droplet jetting means portion that has a plurality of nozzles and is used for the liquid droplet jetting apparatus.

The liquid droplet jetting apparatus shown in Fig. 2 (A) includes therein liquid droplet jetting means 106. When liquid droplets are jetted by this means 106, a desired pattern is acquired on a treated article 102.

In Fig. 2(A), the treated article 102 is conveyed from an inlet 104 into a casing 101 and after being treated, is taken out from an outlet 105. The treated article 102 is mounted onto a table 103 inside the casing 101 and the table 103 moves on rails 110a and 110b that connect the inlet and the outlet.

A supporting portion of liquid droplet jetting means 107 supports liquid droplet jetting means 106 for jetting liquid droplets and moves in parallel with the table 103. When the treated article 102 is carried into the casing 101, the supporting portion of liquid droplet jetting means 107 simultaneously moves to a predetermined position at which the liquid droplet jetting means 106 executes the first liquid droplet jetting treatment. Since the movement of the liquid droplet jetting means 106 to the initial position is conducted at the time of carrying-in or carrying-out of the treated article, the jetting treatment can be carried out with high efficiency.

The liquid droplet jetting treatment is started after the treated article 102 reaches the predetermined position at which the droplet jetting means 106 is in the standby state, by the movement of the table 103. The liquid droplet jetting treatment is accomplished by the combination of the relative movement between the supporting portion of liquid droplet jetting means 107 and the treated article 102 and jetting of the liquid droplets from the liquid droplet jetting means 106 supported by the supporting portion of liquid droplet jetting means 107. A desired pattern can be formed on the treated article 102 by controlling the moving speeds of the treated article 102 and the supporting portion of liquid droplet jetting means 107 and the jetting cycle of the liquid droplets from the liquid droplet jetting means 106. When a treatment for which high accuracy is required such as the liquid droplet jetting treatment is conducted, it is preferred to stop the movement of the table 103 and to serially scan only the supporting portion of liquid droplet jetting means 107 having high controllability. Furthermore, the liquid droplet jetting treatment may be carried out not only by scanning of the liquid droplet jetting means 106 by the supporting portion of liquid droplet jetting means 107 in one direction, but also by reciprocating or repeating reciprocation of the scanning.

A raw material liquid is supplied from a raw material liquid feed portion 109 installed outside the casing 101 into the casing and further into a liquid chamber inside the liquid droplet jetting means 106 through the supporting portion liquid droplet jetting means 107. Control means 108 installed outside the casing 101 controls the supply of the raw material liquid but control means incorporated in the supporting portion of liquid droplet jetting means 107 inside the casing 101 may control the supply, too.

The control means 108 installed outside the casing 101 similarly controls the movements of the table 103 and means supporting portion of liquid droplet jetting means 107.

Though not shown in Fig. 2(A), a sensor for positioning to a pattern formed in advance on the treated article 102, gas introduction means for introducing a gas into the casing 101, exhaust means from inside the casing, means for heat treating a substrate, means for irradiating light to the treated article, means for measuring various property values such as a temperature, a pressure, and so forth, may be further installed, whenever necessary. The control means 108 installed outside the casing 101 can collectively control these means, too.

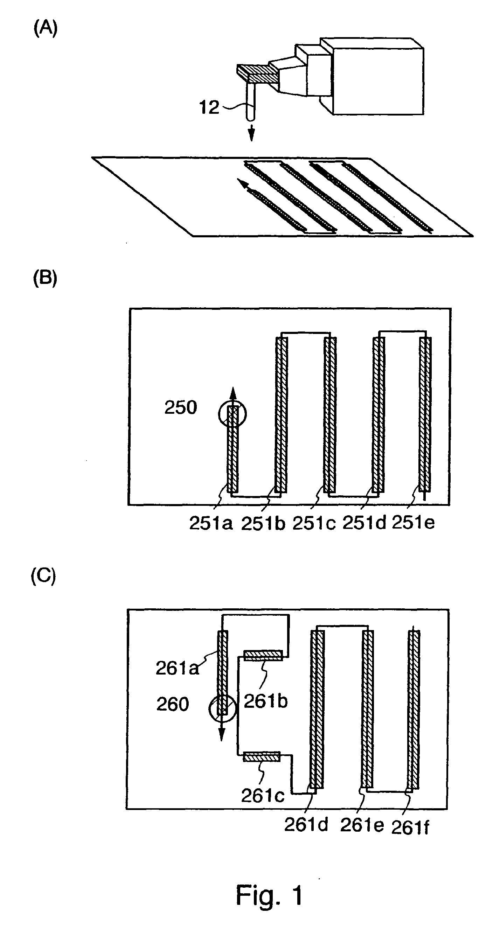

Next, the internal construction of the liquid droplet jetting means 106 will be explained. Fig. 3 is a view when the section of the liquid droplet jetting means 106 shown in Fig. 1(A) is viewed in a longitudinal direction. The liquid droplet jetting means 106 is connected to the liquid droplet jetting means supporting portion that is not hereby illustrated.

The raw material liquid supplied from outside into the liquid droplet jetting means passes through a common liquid chamber passage 122 and is then distributed to each nozzle 129 for jetting the liquid droplets. Each nozzle portion includes a fluid resistance portion 123 disposed for loading the raw material liquid into the nozzle, a pressurization chamber 124 for pressurizing the raw material liquid and jetting it outside the nozzle, and liquid droplet jetting ports 126.

A piezoelectric element 125 having a piezoelectric effect such as lead zirconium titanate (Pb(Zr, Ti)O₃), etc, that undergoes deformation upon application of a voltage is arranged on the sidewalls of the pressurization chamber 124. Therefore, when the voltage is applied to the piezoelectric element 125 arranged in the object nozzle, the droplets 127 inside the pressurization chamber 124 can be extruded and jetted outside. Since each piezoelectric element is insulated by an insulator 128 contacting each the piezoelectric element, the piezoelectric elements do not come into electric contact with one another and jetting from the individual nozzles can be controlled.

Though this embodiment describes the method of the so-called "piezoelectric system" using the piezoelectric element for jetting the liquid droplets, a method that lets a heat generation member generate heat and bubbles to extrude the liquid droplets may also be employed. In this case, the embodiment uses a structure in which the heat generation member replaces the piezoelectric element 125.

In the nozzle portion 129 for jetting the liquid droplets, wettability of the raw material liquid with each of the common liquid chamber passage 122, the fluid resistance portion 123, the pressurization chamber 124 and the liquid droplet jetting ports 126 becomes important. Therefore, a carbon film, a resin film, and so forth, for adjusting wettability with the materials may be formed in each passage.

By the means described above, the liquid droplets 127 can be applied drop-wise onto the treated article 102.

Figs. 4(A) to 4(C) schematically illustrate the bottom portion of the liquid droplet jetting means 106 shown in Fig. 2(A). In Fig. 4(A), the liquid droplet jetting ports 132 are linearly arranged on the bottom surface of the liquid droplet jetting means 106. In Fig. 4(B), in contrast, the liquid droplet jetting ports 136 are arranged in two rows on the bottom surface of the liquid droplet jetting means 106 and each row is deviated by a half pitch from the other. In Fig. 4(C), further, the liquid droplet jetting ports 136 are arranged in two rows without deviation of the pitch. In the arrangement shown in Fig. 4(C), the liquid droplets are first jetted from the liquid droplet jetting ports 140 of the first stage and after the passage of a certain time, similar liquid droplets are jetted from the liquid droplet jetting port 140 to the similar position so that the same liquid droplets can be deposited to a greater thickness before the liquid droplets that have already been jetted onto the substrate are dried or solidified. It is also possible to cause the liquid droplet jetting ports 140 of the second stage to function as a spare when the nozzle portion of the first stage gets clogged by the liquid droplets, and so forth.

Fig. 2(B) shows a liquid droplet jetting apparatus having a twin liquid droplet jetting means structure in which two liquid droplet jetting means 206 of the liquid droplet jetting apparatus shown in Fig. 2(A) are disposed. Incidentally, the same reference numeral is put to the same constituent element as in Fig. 2(A) and the explanation will be omitted. This apparatus can execute jetting of the liquid droplets using two kinds of raw material liquids by a single scanning operation. In other words, while the formation of a pattern is made by jetting of the liquid droplets A by the liquid droplet jetting means 206a, the formation of a pattern is made with a slight time lag by jetting of the liquid droplets B by the liquid droplet jetting means 206b so that continuous pattern formation can be carried out. Reference numerals 209a and 209b denote raw material liquid feed portions. These portions accommodate the raw material liquid of the liquid droplets A and B used by the respective liquid droplet jetting means and supply them.

This embodiment uses the apparatus shown in Fig. 2(B) and forms a resist film by use of a resist solution as the raw material liquid. Incidentally, it is advisable to form in advance a film of a surface active agent such as hexamethyldisilazane (HMDS), etc, for improving adhesion of the resist film on a resist film formation portion on the treated article 202.

First, the liquid droplets of HMDS are jetted from a plurality of liquid droplet jetting ports provided to the liquid droplet jetting means 206a and a linear HMDS film in which a pattern formed by each liquid droplet is connected continuously each other is formed on the treated article 202. The liquid droplets of the resist are further jetted from a plurality of liquid droplet jetting ports provided to the liquid droplet jetting means 206b and a resist film in which a pattern formed by each liquid droplet is connected continuously each other is formed on the HMDS film.

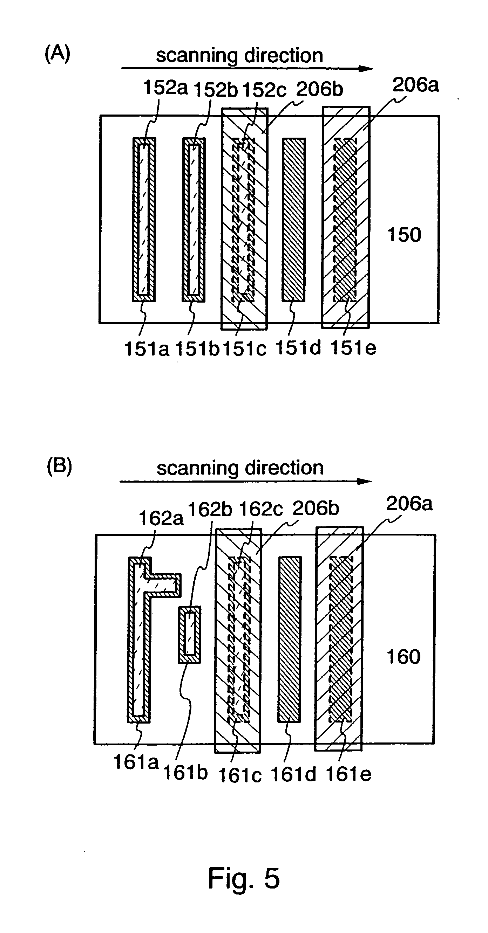

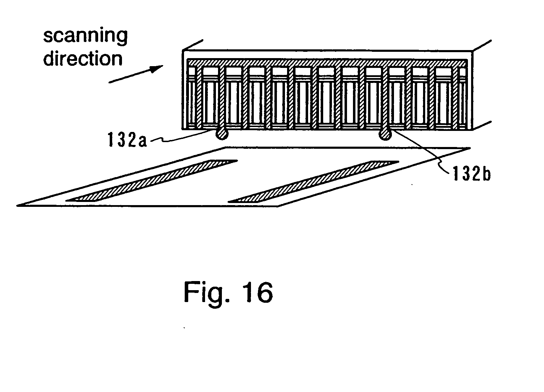

The pattern of the resist film formed by this method will be explained with reference to Figs. 5(A) and 5(B). In Fig. 5(A), a plurality of HMDS films 151a to 151e formed on the treated article 150 is formed when the liquid droplets are jetted from all the liquid droplet jetting ports provided to the liquid droplet jetting means 206a at the same time interval. Further, linear resist films 152a to 152c are formed on the HMDS films 151a to 151e when the liquid droplets are jetted from all liquid droplet jetting ports provided to the liquid droplet jetting means 206b at the same time interval in the same way as the liquid droplet jetting means 206a. Incidentally, it will be assumed that the liquid droplet jetting means 206b starts scanning with a certain time lag from the liquid droplet jetting means 206a and conducts scanning at the same scanning speed as that of the liquid droplet jetting means 206a. As shown in Fig. 16, it is also possible to form a T-shaped (or 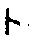 -shaped) HMDS film 161a and resist film 162a shown in Fig. 5(B) or to simultaneously form an HMDS film 161b and resist film 162b having different length shown in Fig. 5(B) on the same treated article 160 or HMDS films 161c to 161e similar to those shown in Fig. 5(A) by disposing a process in which the liquid droplets are jetted from only specific liquid droplet jetting ports (132a and 13b) from among a plurality of liquid droplet jetting ports in the scanning processes of the liquid droplet jetting means 206a and 206b.

Incidentally, after formation, the resist film is heat treated and may be used as a resist mask. In this case, the shape of the resist film becomes the shape of the resist mask. It is therefore possible to drastically reduce the use amount of the resist material and to eliminate the process step relating to photolithography. Incidentally, when it is desired to form a resist mask having a shape more precise than the resist mask described above, exposure and development processes using a photo-maskmay be conducted before the resist film described above is heat treated. In this case, the use amount of the resist material can be drastically reduced, too.

When the liquid droplet jetting method is employed as described above, the resist film can be formed partially at portions at which the resist mask needs be formed. Therefore, the use amount of the resist material can be drastically reduced in comparison with the spin coat method in which almost all the resist material supplied drop-wise scatters. Incidentally, when it is necessary to form the resist film on the entire surface of the substrate, the resist film may as well be formed on the substrate as a whole by the method described above. In any case, the method described above can drastically reduce the use amount of the resist material.

As described above, when the liquid droplet jetting method is employed, the resist film can be formed partially only at the portions at which the resist mask needs to be formed. Therefore, the use amount of the resist material can be drastically reduced in comparison with the spin coat method in which almost all the resist material supplied drop-wise scatters. Incidentally, this embodiment uses the method that jets the liquid droplets but the resist film may be partially formed by continuously jetting the resist solution for a predetermined time by use of a dispenser system.

As represented by this embodiment, the use amount of the resist material can be drastically reduced by forming the resist film by use of the liquid droplet jetting method or the liquid jetting method without using the spin coat method.

### (Embodiment 2)

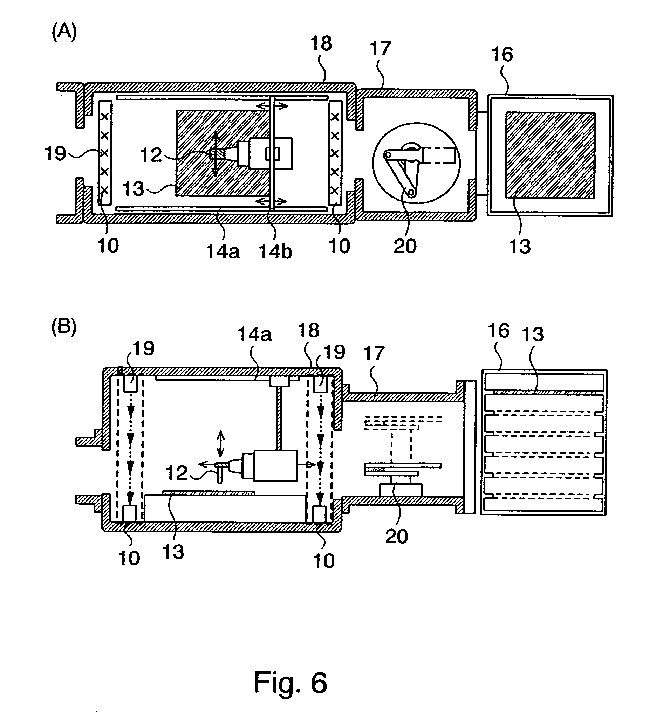

In this embodiment, a method of partially conducting plasma treatment such as etching, ashing, film formation, etc, by use of the apparatus shown in Figs. 6(A) to Fig. 7(D) will be explained.

Fig. 6(A) is a top view of an example of the plasma treatment apparatus used in the present invention and Fig. 6(B) is a sectional view. In the drawings, a treated article 13 such as a glass substrate or a resin substrate typified by a plastic substrate each having a desired size is set to a cassette chamber 16. A conveying system of the treated article 13 includes horizontal conveying. When a substrate having a meter angle of the fifth generation et seq is used, however, vertical conveying that keeps the substrates under a longitudinal state may be employed to reduce an occupying area of a conveyor machine.

Inside a conveying chamber 17, the treated articles 13 arranged in the cassette chamber 16 are conveyed by a conveying mechanism (robot arm) 20 into a plasma treatment chamber 18. The plasma treatment chamber 18 that is adjacent to the conveying chamber 17 includes therein gas flow control means 10, cylindrical plasma treatment means 12 having electrodes for generating plasma, rails 14a and 14b for moving the plasma treatment means 12, movement means for moving the treated articles 13, and the like.

The gas flow control means 10 is for dust proofing and controls a gas stream in such a manner as to block off from the outside air by use of an inert gas blown out from a blow-out port 19. The plasma treatment means 12 moves to a predetermined position on the rail 14a arranged in the conveying direction of the treated articles 13 or on the rail 14b arranged in a direction vertical to the conveying direction.

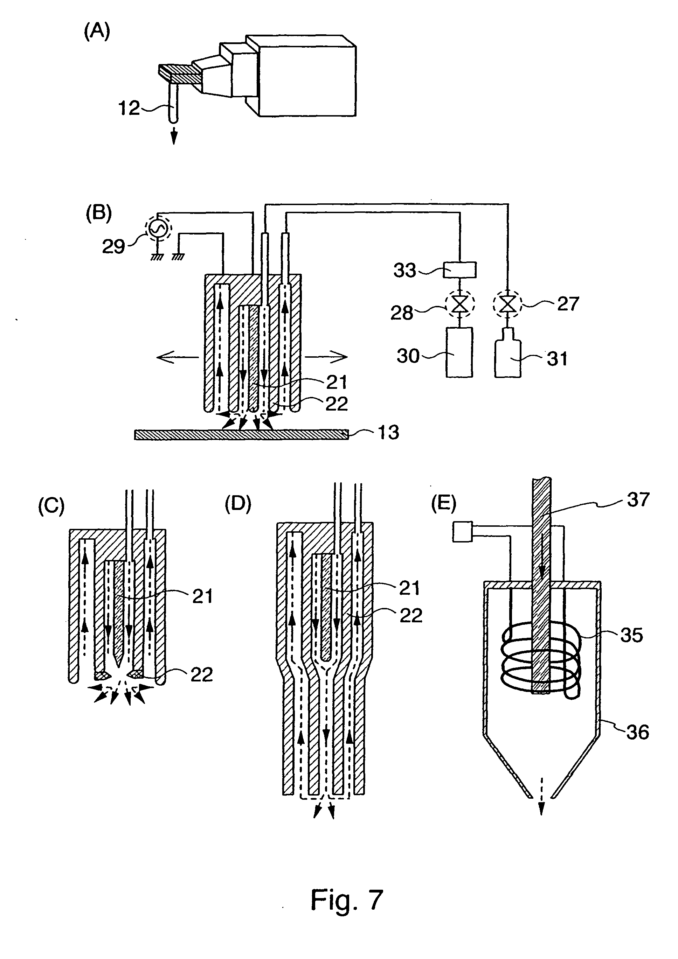

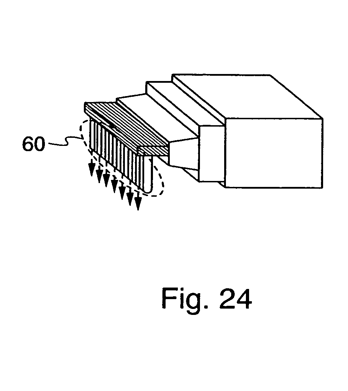

Next, the detail of the plasma treatment means 12 will be explained with reference to Figs. 7(A) to 7(D). Fig. 7(A) shows a perspective view of the cylindrical plasma treatment means 12 having electrodes for generating plasma. Figs. 7(B) to 7(D) are sectional views of a set of electrodes provided to the plasma treatment means 12. Incidentally, the plasma treatment means may have either a construction in which one set of electrodes is alone disposed as shown in Fig. 7(A) or a construction in which a plurality of sets of electrodes are arranged as shown in Fig. 24. Incidentally, in the plasma treatment apparatus shown in Fig. 24, the plasma treatment means 60 has a construction in which a plurality of sets of electrodes is arranged as shown in any of Figs. 7(B) to 7(D).

In Fig. 7(B), the dotted line represents a path of a gas. Reference numerals 21 and 22 denote electrodes made of a metal having conductivity such as aluminum or copper. The surface of each electrode is covered with a solid dielectric. A first electrode 21 is connected to a power source (radio frequency power source) 29. A cooling system (not shown) for circulating cooling water may be connected to the first electrode 21. When the cooling system is disposed, heat-up when the surface treatment is continuously carried out can be prevented by the circulation of cooling water and efficiency by the continuous treatment can be improved. A second electrode 22 has a shape surrounding the first electrode 21 and is electrically grounded. Each of the first and second electrodes 21 and 22 has at its distal end a cylindrical shape having a nozzle-like aperture for the gas. A processing gas is supplied from gas feed means (gas bomb) 31 into a space between the first and second electrodes 21 and 22 through a valve 27. Consequently, the atmosphere of this space is substituted. When a high frequency voltage (10 to 500 MHz) is supplied under this state from the high frequency power source 29 to the first electrode 21, plasma is generated inside the space. When a reactive gas flow generated by this plasma and containing chemically active excitation seeds such as ions and radicals is blown to the surface of the treated article 13, plasma treatment such as etching, ashing, CVD, etc, can be partially carried out on the surface of the treated article 13. Incidentally, the distance between the blow-out port of the reactive gas and the substrate is 3 mm or below, preferably 1 mm or below and more preferably 0.5 mm or below. This distance can be adjusted by fitting a dedicated sensor.

Incidentally, the processing gas charged into the gas feed means (gas bomb) 31 is set appropriately in accordance with the processing conducted for the treated article 13. When the processing gas is an oxygen gas (O₂), the ashing treatment can be conducted. When a silane (SiH₄) gas or a hydrogen gas (H₂) is introduced as the processing gas, an amorphous silicon film can be formed. Further, when a phosphine (PH₃) gas or the like is introduced, an N type amorphous silicon film can be formed. Furthermore, a conductor film of aluminum or the like can be formed by using triisobutylaluminum (i-C₄H₉)₃Al. Titanium nitride (TiN) can be further formed in film by using titanium tetrachloride (TiCl₄) and ammonia (NH₃).

The exhaust gas is introduced into the exhaust means 30 through a filter 33 for removing dust admixed in the gas and through a valve 28. It is also possible to purify the exhaust gas introduced into the exhaust means 30 and to utilize again the gas remaining un-reacted as the processing gas.

Figs. 7(C) and 7(D) show sectional views of one set of electrodes having a different structure from Fig. 7(B) and provided in the plasma processing means 12. In one set of the electrodes shown in Fig. 7(C), the distal end of each of the first and second electrodes 21 and 22 has a sharp angle shape. These electrodes 21 and 22 have a construction in which the distal end of the extension of the first electrode 21 and the distal end of the second electrode 22 cross each other at the discharge port. One set of the electrodes shown in Fig. 7(D) has a construction in which the second electrode 22 extends much more than the first electrode 21 and the reaction gas generated between the first and second electrodes 21 and 22 can be discharged outside from the discharge port through the space encompassed by the second electrode 22.

In the plasma treatment apparatus shown in Figs. 6(A) and 6(B), the plasma treatment means 12 can alternately scan in the row direction and in the column direction. For example, when the plasma treatment means 12 alternately scans in the row direction and in the column direction and the timing of discharge of the reactive gas is controlled, a plurality of treated regions 251a to 251e having a thinly elongated shape can be disposed on the treated article 250 as shown in Fig. 1(B). Treated regions 261b and 261c having an elongated shape in the row direction or treated regions 261a and 261d to 261f having an elongated shape in the column direction can also be disposed on the treated article 260 as shown in Fig. 1(C).

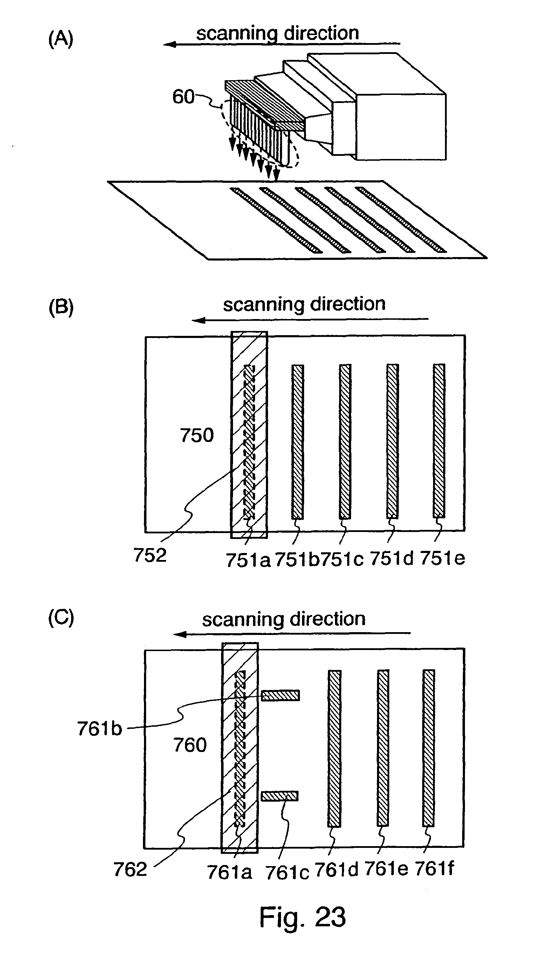

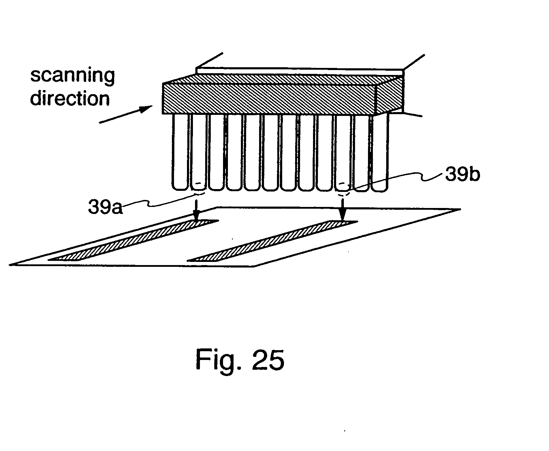

Incidentally, the plasma treatment in the plasma treatment apparatus is not limited to the one described above. For example, the following treatment can be executed by use of a plasma treatment apparatus having plasma treatment means having a plurality of sets of electrodes as shown in Fig. 24. For example, a plurality of treatment regions 751a to 751e having an elongated shape shown in Fig. 23(B) can be disposed on the treated article 750 by scanning the plasma treatment means 752 in the either one of the row or column directions (Fig. 23(A)) and controlling the discharging timing of the reactive gas. Incidentally, scanning of the plasma treatment means 752 is not limited to one direction described above but may be made back and forth or to the right and left. As shown in Fig. 25, when control is made so that the reactive gas is discharged from only specific reactive gas discharge ports 39a and 39b among a plurality of reactive gas discharge ports of the plasma treatment means 762, treated regions 761b and 761c having a thinly elongated shape in a direction parallel to the scanning direction and treated regions 761a and 761d to 761f having a thinly elongated shape in a direction vertical to the scanning direction can be simultaneously formed on the same treated article 760.

When the etching gas is introduced into the processing gas, each plasma treatment region is partially etched. When a CVD gas (gas for film formation) is introduced into the processing gas, a film is formed in each plasma treatment region.

When a plasma treatment apparatus operating under an atmospheric pressure or a pressure near the atmospheric pressure (5 to 800 Torr) is employed, evacuation required for a pressure reduction apparatus and the time for releasing to the atmosphere are not necessary, and a complicated vacuum system need not be arranged. A treatment chamber of a pressure reduction apparatus provided particularly to an apparatus for processing a large-scale substrate essentially becomes great in scale and a processing time for achieving a pressure reduction state inside the treatment chamber gets elongated. Therefore, the apparatus that operates at or near the atmospheric pressure is effective and the production cost can be reduced. When plasma treatment means 60 including a plurality of sets of electrodes that are arranged for generating plasma such as the one shown in Fig. 23(A) is used, plasma treatment can be carried out by conducting scanning once in one direction and is particularly effective for the large scale substrate.

### (Embodiment 3)

In this embodiment, a method of partially forming a film under an atmospheric pressure or a pressure approximate to the atmospheric pressure by use of a method different from the method of the second embodiment will be explained with reference to Fig. 7(E).

In this embodiment, only the construction of the plasma generation means is different from that shown in Figs. 6 (A) and 6(B) and the partial film formation treatment is conducted by use of the same apparatus for the rest of portions. Therefore, only different portions from Fig. 7(A) that is an explanatory view of the plasma treatment means 12 shown in Figs. 6(A) and 6(B) will be explained.

Unlike the plasma treatment means 12 shown in Fig. 7(A), this embodiment includes, inside a casing 36, film formation means in which the raw material is held in a pipe 37 passing through a filament 35 wound in a coil shape as shown in Fig. 7(E). The raw material heated by the filament 35 upon the supply of the current evaporates and is discharged from the pipe 37 and a film can be formed on the treated article.

Known materials such as aluminum (Al) may be used as the raw material.

Unlike the plasma treatment means, the gas feed means and the exhaust means need not always be disposed.

### (Embodiment 4)

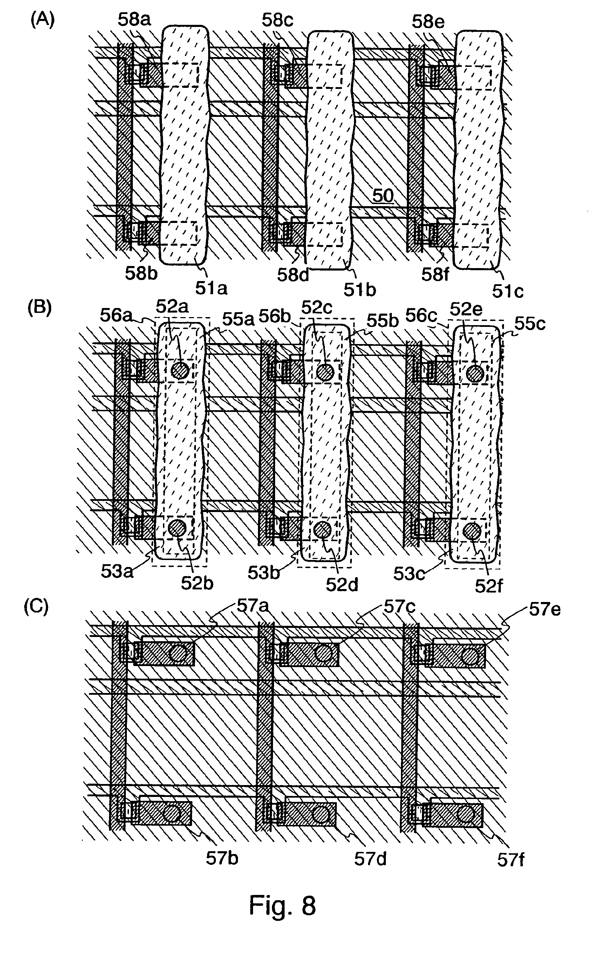

In this embodiment, a method of forming contact holes by forming a resist mask by using the liquid droplet jetting apparatus shown in the first embodiment and then conducting partial etching by the plasma treatment apparatus shown in the second embodiment will be explained with reference to Figs. 8(A) to 8(C).

A plurality of resist films 51a to 51c is formed on the film 50 formed on the substrate by the method shown in the first embodiment (Fig. 8(A)). Incidentally, the film 50 in this embodiment is an insulating film of a silicon nitride film, a silicon oxide film, or the like and a plurality of gate wirings 58a to 58f formed of a conductor film and TFT connected thereto wirings are formed below the film 50.

Resist masks 53a to 53c having a plurality of openings 52a to 52f are formed by exposure and development.

Next, the reactive gas is partially blown to an inside portion (portion encompassed by dotted line 55a) of the portion at which the resist mask 53a is formed, by using the plasma treatment apparatus shown in the second embodiment. Consequently, the film 50 of the portions exposed from the openings 52a and 52b can be etched. The plasma treatment means 12 is thereafter moved serially and the reactive gas is partially blown to only the inside portion (portion encompassed by dotted lines 55b and 55c) of the portion at which the resist masks 53b and 53c are formed by use of the resist masks 53b and 53c as the mask, thereby conducting partial etching treatment and etching the film 50 of the portions exposed from the openings 52c to 52f formed in the resist masks 53b and 53c. Incidentally, the plasma treatment apparatus may have one set of electrodes disposed alone or a plurality of sets of electrodes.

After etching, the processing gas of the plasma treatment apparatus used for etching is switched to an oxygen (O₂) gas and the reactive gas is partially blown for ashing to the portion (portion encompassed by dotted line 56a) which is a little larger than the portion where the resist mask 53a is formed by use of the plasma treatment apparatus in consideration of an alignment error. The resist mask 53a is then removed. Similarly, the ashing treatment is applied to the portions 56b and 56c which are a little larger than the portion where the resist masks 53b and 53c are formed in consideration of the error and the resist masks 53b and 53c are removed. The resist masks 53a to 53c may be completely removed by use of a peeling solution after ashing. Incidentally, the ashing treatment need not always be conducted partially but when it is conducted in succession to the etching treatment as described above, the number of times of carrying in and out the substrate can be reduced and when the ashing treatment is conducted partially, the amount of the gas used can be reduced.

The wiring contact holes 57a to 57f can be formed in the film 50 in the manner described above (Fig. 8(C)).

It is possible to use not only a resist mask having a pattern in which openings are aligned in one row in the row direction and a plurality of openings is aligned in the column direction as shown in Fig. 8(B) but also a plurality of resist masks having a pattern in which a plurality of openings is aligned in the row direction and in the grid arrangement.

Since the contact holes are formed in the manner described above, the resist material and the use amount of the etching gas necessary for forming the contact holes can be drastically reduced. Since the plasma treatment such as etching and ashing is conducted at or near the atmospheric pressure, a complicated vacuum system need not be arranged and the apparatus and the setup do not become complicated.

### (Embodiment 5)

In this embodiment, a method of forming the contact holes by using only the plasma treatment apparatus shown in the second embodiment without using the mask will be explained.

In the plasma treatment means, the electrodes for generating plasma are controlled so that they can be arranged in the same gap as the gap for forming the contact holes. The reactive gas is discharged from the electrodes for generating plasma and the contact holes are formed. Incidentally, the discharge port of the reactive gas preferably has a size that is the same as, or smaller than, the size of the contact holes to be formed.

### (Embodiment 6)

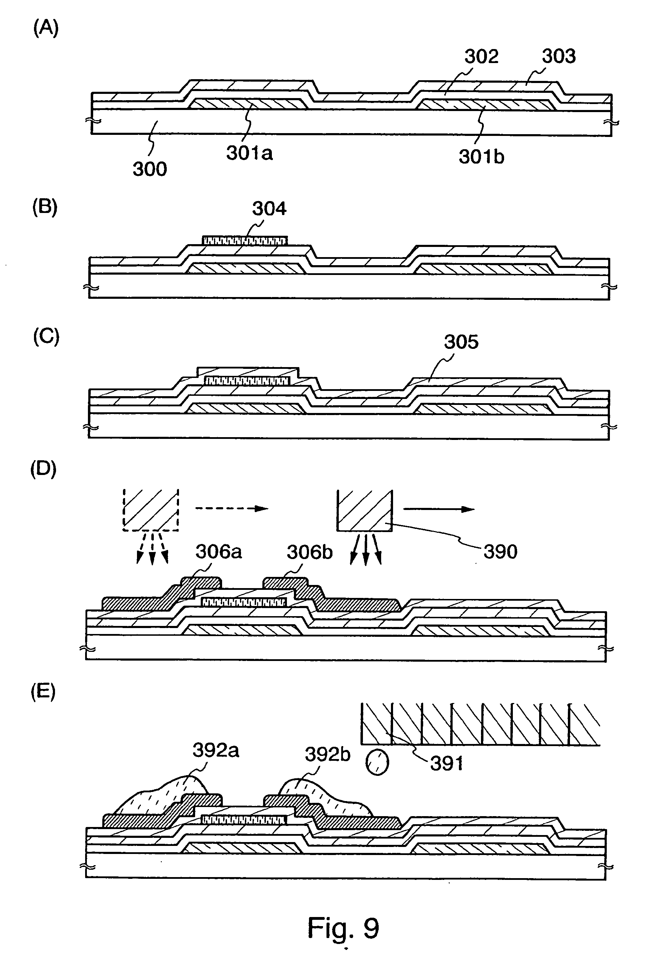

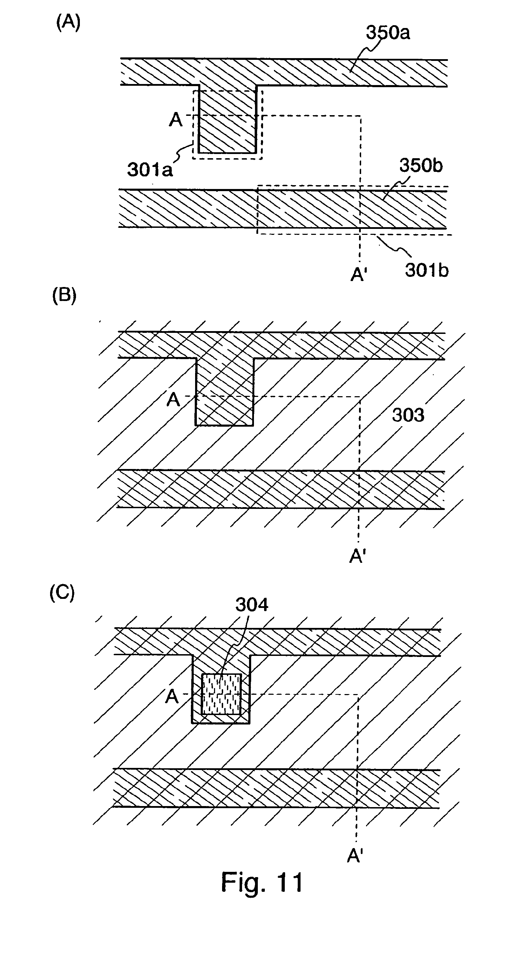

A manufacturing method of a display device according to the invention will be explained with reference to the sectional views of Fig. 9(A) to Fig. 10(F) and the top views of Fig. 11(A) to Fig. 13(C). The manufacturing method of the display device represented by this embodiment includes the step of partially applying the plasma treatment (etching, ashing, film formation). Incidentally, the manufacturing method hereby shown merely represents an embodiment of the invention and the manufacturing method of the display device according to the invention is not limited the manufacturing method of this embodiment. The structure of the TFT is not limited, either, to the structures shown in Fig. 9(A) to Fig. 13(C).

In the manufacturing method of the display device according to the invention, the use amount of the resist film can be drastically reduced by partially forming the resist film on only the necessary portions and because the manufacturing method includes the step of partially conducting the treatment such as the film formation, etching and ashing at or near the atmospheric pressure, vacuum equipment and the time for establishing vacuum are not necessary. Therefore, in comparison with a manufacturing method of the display device using conventional technologies, the manufacturing method of this embodiment can lower the raw material cost, the equipment cost and the process time and can reduce the production cost. The manufacturing method having such a lost cost is effective particularly for a large-scale display device having a substrate size of the fifth generation (1,000 x 1,200 mm²) or more.

A gate electrode 301a, a capacitance electrode 301b, a gate wiring 350a and a capacitance wiring 350b are formed on a substrate 300. A transparent substrate having a substrate size of 1,000 x 1,200 mm² and formed of glass or a plastic is used as the substrate 300. The gate electrode 301a, the capacitance electrode 301b, the gate wiring 350a and the capacitance wiring 350b are formed into the same layer by the steps of serially forming films of aluminum (Al) containing neodymium (Nd), and molybdenum (Mo) on the entire surface of the substrate to form a conductor film, then forming a resist mask on this conductor film and etching the conductor film by using the resist mask as a mask. The resist mask is formed by first forming a resist film by use of a spin coat method and processing the resist film by photolithography. Besides aluminum (Al) containing neodymium (Nd), a conductive material such as chromium (Cr) may be used as the material of the gate electrode 301a, the capacitance electrode 301b, the gate wiring 350a and the capacitance wiring 350b. A laminate film obtained by serially laminating titanium (Ti), Al and Ti may also be used. The substrate 300 may have sizes other than the size described above.

Besides the formation of the conductor film on the entire surface of the substrate described above, it is also possible to partially form the conductor film at the atmospheric pressure by use of the apparatus represented in the second or third embodiment and to form the gate electrode 301a, the capacitance electrode 301b, the gate wiring 350a and the capacitance wiring 350b.

Fig. 11(A) is a top view of a part of the substrate on which the gate electrode 301a and the capacitance electrode 301b are formed. In Fig. 11(A), the gate electrode 301a and the gate wiring 350a are formed integrally with each other. The capacitance electrode 301b and the capacitance wiring 350b are formed integrally with each other, too.

Next, an insulating film 302 covering the gate electrode 301a and the capacitance electrode 301b is formed. An insulating film such as a silicon nitride film or a silicon oxide film, or a laminate film of a silicon nitride film, a silicon oxide film, etc. is used as the insulating film 302. The upper part of the gate electrode 301a in the insulating film 302 operates as a gate insulating film.

Next, a semiconductor film 303 is formed on the insulating film 302 (Fig. 9(A), Fig. 11(B)). The semiconductor film 303 is formed by depositing an amorphous silicon film, etc, on the entire substrate. Incidentally, an impurity that imparts an N type or a P type is not particularly added to the semiconductor film 303.

As to the formation of the semiconductor film 303, it is also possible to employ means for partially forming the semiconductor film 303 at portions at which TFT must be formed at or near the atmospheric pressure by use of the plasma treatment apparatus shown in the second embodiment besides the formation of the semiconductor film 303 on the entire substrate.

Next, a protective film 304 is formed on a portion of the semiconductor film 303 that is to operate as a channel region of the TFT (Fig. 9(B), Fig. 11(C)). The protective film 304 is formed by the step of forming an insulating film such as a silicon nitride film on the entire surface of the substrate, forming a resist mask on this insulating film and etching the insulating film by using the resist mask as a mask. The resist mask is formed by forming a resist film by use of a spin coat method and then processing the resist film by photolithography.

Besides the formation of the insulating film such as the silicon nitride film on the entire surface of the substrate described above, the protective film 304 may also be formed by partially forming the insulating film at the atmospheric pressure by use of the method described in the second or third embodiment.

Next, a source wiring 308 and a wiring 309 each formed of a laminate film of an N type semiconductor film 305 and a conductor film 306a or 306b are formed. Incidentally, the wiring 309 is disposed to connect the TFT and pixel electrodes. The formation method of the source wiring 308 and the wiring 309 will be hereinafter explained.

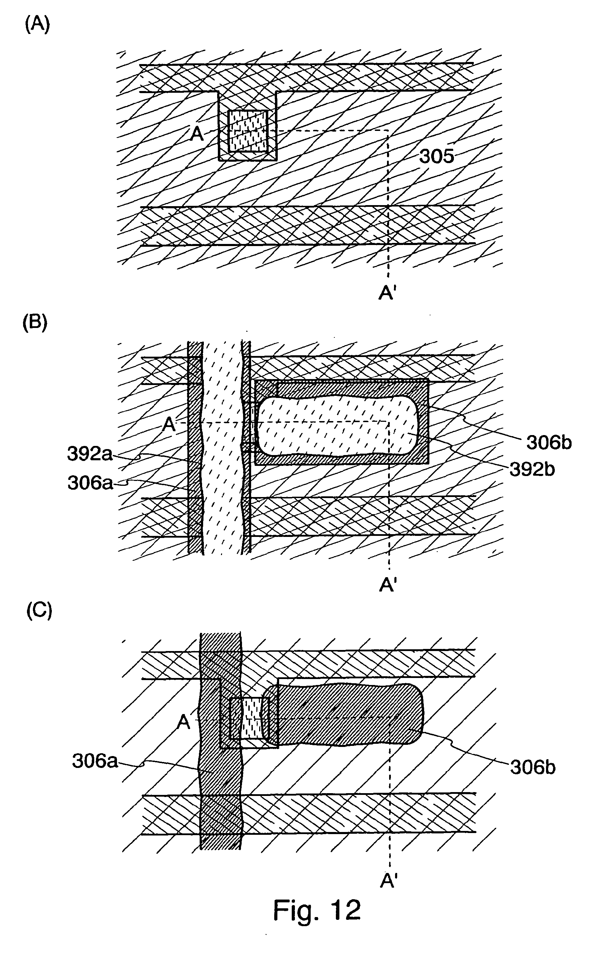

First, the N type semiconductor film 305 is formed (Fig. 9(C)), Fig. 12(A)). In this embodiment, an amorphous silicon film doped with phosphorous is used as the N type semiconductor film 305. After the N type film 305 is formed on the entire substrate, a plurality of conductor films 306a and 306b isolated in an island form is partially formed on the N type semiconductor film 305 by use of the apparatus 390 shown in the second or third embodiment. It is also possible to partially form the film at portions at which the TFT is to be formed, by use of the apparatus shown in the second or third embodiment besides the formation of the N type semiconductor film 305 on the entire substrate. When the film is partially formed, etching may be carried out partially by use of the apparatus shown in the second embodiment. A film prepared by serially laminating molybdenum (Mo), aluminum (Al) and molybdenum (Mo) is used for the conductor films 306a and 306b. However, this is not restrictive, and titanium (Ti), for example, may be used in place of Mo. The conductor films 306a isolated in the island form are formed in such a manner as to form the source wiring 308 and the conductor films 306b isolated in the island form are formed in such a manner as to form the wiring 309 that connects the TFT to the pixel electrodes.

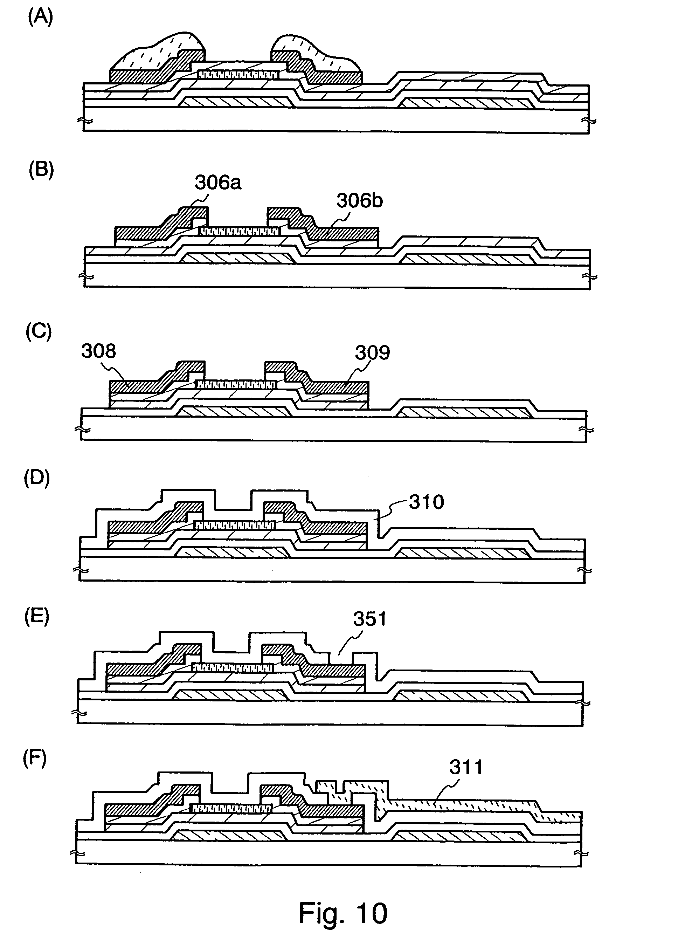

Next, resist masks 392a and 392b are formed on the conductor films 306a and 306b (Fig. 9(E), Fig. 12(B)) and the conductor films 306a and 306b are etched by using the resist masks 392aand392bas the mask (Fig. 10(A), Fig. 12(C)). To form the resist mask 392a and 392b, the liquid droplet jetting apparatus 391 shown in the first embodiment is used hereby. Etching is carried out partially at or near the atmospheric pressure by use of the apparatus shown in the second embodiment. Since the conductor films 306a and 306b are formed by partial film formation as described above, the use amount of the raw materials relating to the formation step of the conductor films 306a and 306b can be reduced. Since the conductor films 306a and 306b partially formed are processed by using the resist mask, the source wiring 308 and the wiring 309 having a more precise shape can be formed.

Incidentally, the conductor films 306a and 306b need not be shaped into a precise shape, in particular. When they are used in the as-formed shape, the processing step of the conductor films 306a and 306b using the resist masks 392a and 392b need not particularly be disposed.

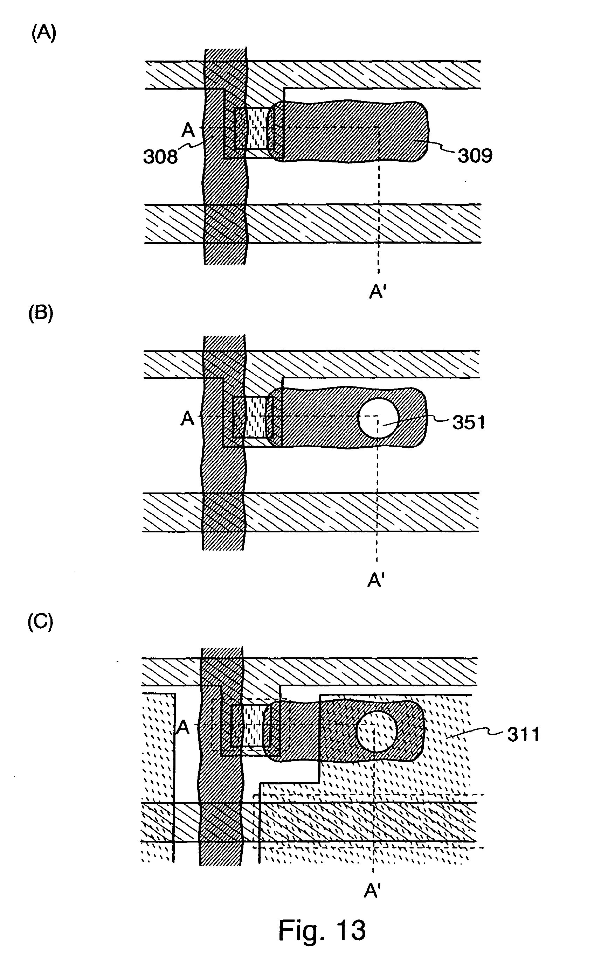

Next, the N type semiconductor film 305 is etched by using a plurality of conductor films 306a and 306b isolated in the island form as a mask (Fig. 10(B), Fig. 13(A)). As a result of the steps described above, the source wiring 308 and the wiring 309 each comprising the laminate of the N type semiconductor film 305 and the conductor film 306a or 306b are formed.

Subsequent to etching of the N type semiconductor film 305, the semiconductor film 303 is etched, too (Fig. 10(C)). During etching of the semiconductor film 303, the protective film 304 previously formed functions as the mask in addition to the conductor films 306a and 306b. The semiconductor film 303 remaining unetched below the protective film 304 operates as the active layer of the TFT.

Next, an insulating film 310 is formed over the source wiring 308 and the wiring 309 (Fig. 10(D)). A silicon nitride film or a silicon oxide film is used for the insulating film 310.

Next, a contact hole 351 penetrating through the insulating film 310 and reaching the wiring 309 is formed (Fig. 10(E), Fig. 13(B)). In this embodiment, the contact hole 351 is formed by the method described in the fifth embodiment.

Next, a pixel electrode 311 is formed (Fig. 10(F), Fig. 13(C)). The pixel electrode is formed by the steps of forming a transparent conductor film such as ITO (Indium Tin Oxide), forming a resist mask on this transparent conductor film by using a spin coat method and then conducting etching by using the resist mask as the mask.

The TFT array substrate on which the TFT for driving the pixel electrodes and the capacitance and pixel electrodes are formed is formed in the manner described above. Incidentally, Fig. 9(A) to Fig. 10(F) are sectional views at a portion A - A' in the top views of Fig. 11(A) to Fig. 13(C).

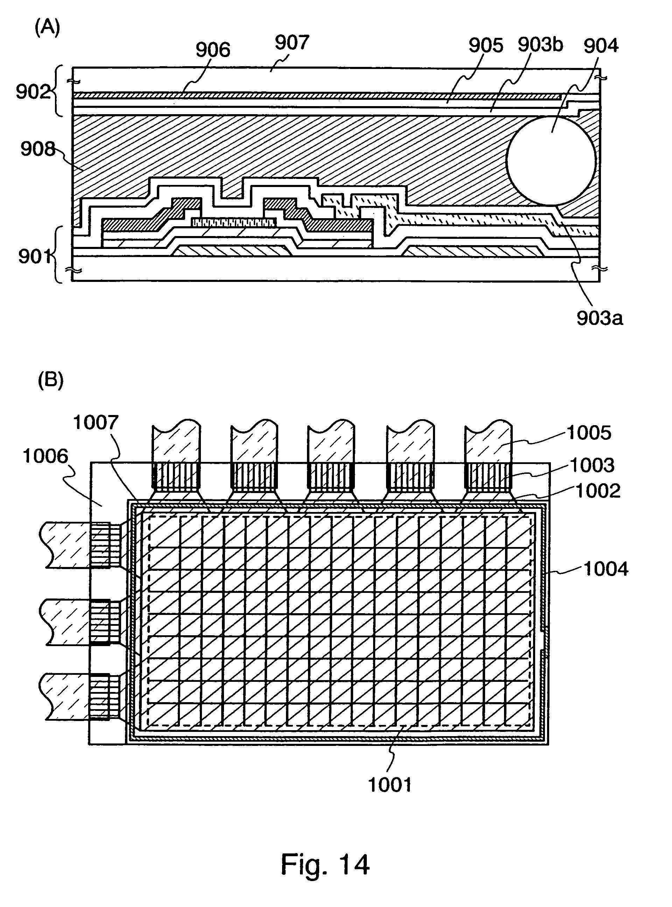

Next, a cell assembly step of the TFT array substrate formed as described above will be explained with reference to Fig. 14(A). After an orientation film 903a is formed on the TFT array substrate 901, the orientation film is subjected to rubbing treatment.

Next, an opposite substrate 902 including a light shielding film 906, an opposite electrode 905 and an orientation film 903b that are formed on a substrate 907 is fabricated. A color filter may be formed, whenever necessary. The rubbing treatment is applied to the orientation film 903b.

Next, after the opposite substrate 902 and the TFT array substrate 901 are bonded to each other by using a sealant, unnecessary portions are sheared off. Furthermore, after a liquid crystal material 908 is charged between the opposite substrate 902 and the TFT array substrate 901, sealing is made. Incidentally, the opposite substrate 902 and the TFT array substrate 901 keep a gap with a spacer 904. An FPC, a polarizer plate and a phase difference plate are further mounted. A liquid crystal display device to which the invention is applied is produced in the manner described above. Incidentally, the liquid crystal display device may well be produced by adding drop-wise the liquid crystal material 908 onto the substrate 907 or the opposite substrate 902 and then bonding both of these substrates.

Fig. 14(B) is a top view of the liquid crystal display device produced by applying the invention. A connection wiring group 1002 is disposed adjacent to a pixel portion 1001 and connects the pixel portion 1001 to an external input/output terminal group 1003 through the connection wiring group 1002. Reference numeral 1007 denotes an opposite substrate. In the pixel portion 1001, wiring groups extending from each connection wiring group 1002 cross one another in a matrix shape and form pixels. A sealant 1004 is formed outside the pixel portion 1001 on the TFT array substrate 1006 and inside the external input/output terminal group 1003. In the liquid crystal display device, a flexible printed wiring board (FPC: Flexible Printed Circuit) 1005 is connected to the external input/output terminal group 1003 and is connected to respective signal lines by the connection wiring group 1002. The external input/output terminal group 1003 is formed of the same conductor film as that of the connection wiring group. The flexible printed wiring board 1005 is formed by forming a copper wiring on an organic resin film such as polyimide, and is connected to the external input/output terminal group 1003 by an anisotropic conductive adhesive.

The embodiment uses the formation of the partial resist film shown in the first embodiment and the partial plasma treatment, etc. shown in the second embodiment during the processing step of the conductor films 306a and 306b but the formation technology of the partial resist film and the application of the partial plasma treatment may be used for other process steps. This means can accomplish the manufacturing of a display device in a lower cost.

Though this embodiment explains about the manufacturing method of the liquid crystal display device, an electro-luminescence display device by the application of the manufacturing method up to the TFT array substrate in this embodiment may be produced, too. In such a case, the circuit construction may be changed appropriately.

### (Embodiment 7)

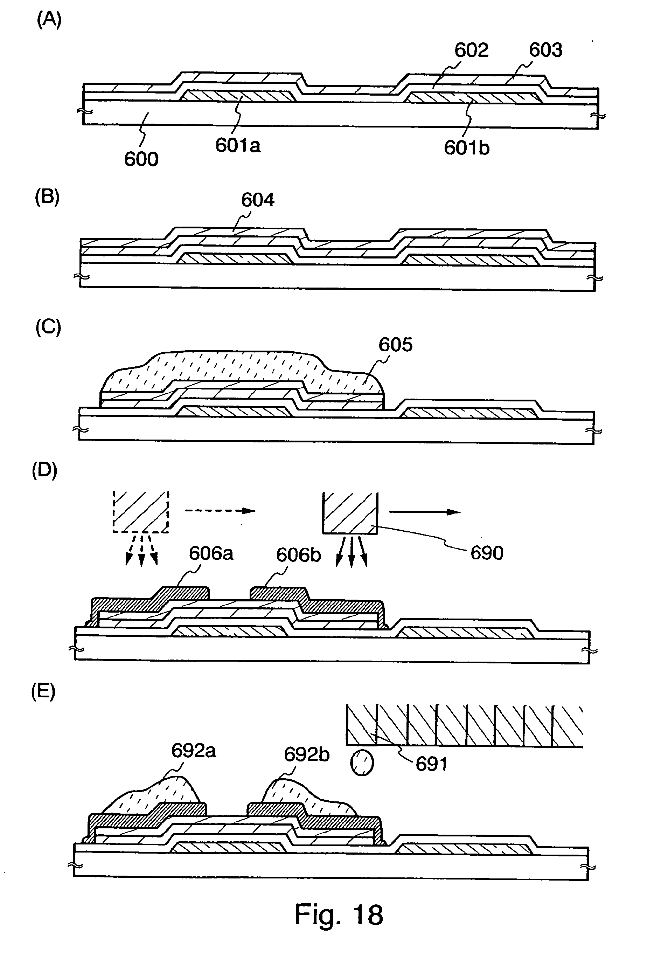

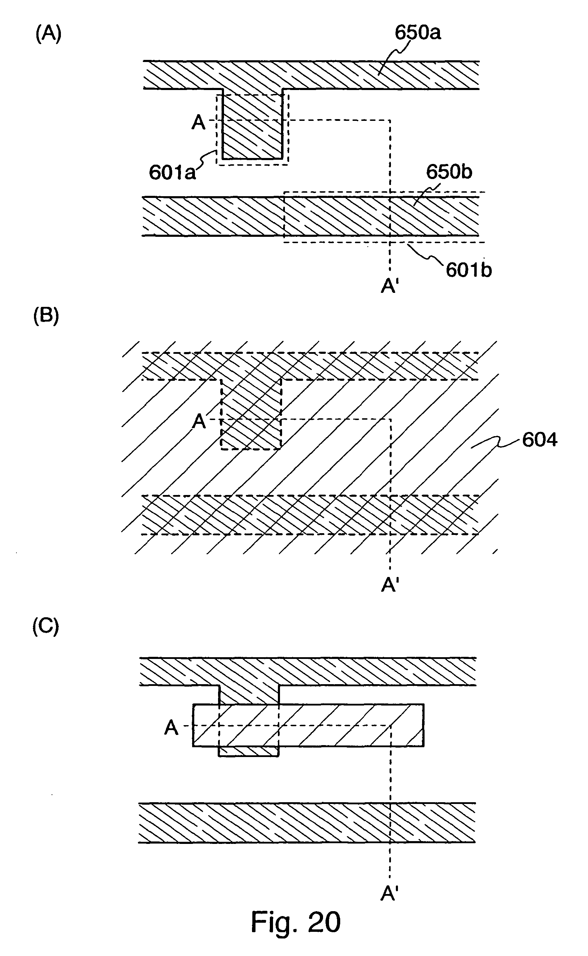

In this embodiment, a manufacturing method of a display device of the invention using TFT having a different laminate structure from that explained in the sixth embodiment will be explained with reference to sectional views of Fig. 18(A) to Fig. 19(E) and top views of Fig. 20(A) to Fig. 22(B). Incidentally, the embodiment hereby shown is one embodiment of the invention and the manufacturing of the display device of the invention is not limited to this embodiment. The structure of the TFT is not limited to those shown in Fig. 18(A) to Fig. 22(B), either.

The manufacturing method of the display device according to this embodiment, as that of explained in the sixth embodiment, drastically reduces the use amount of the resist material by partially forming the resist film in only the necessary portions, and includes the step of partially conducting treatment such as the film formation, etching and ashing at or near the atmospheric pressure. Therefore, in comparison with the manufacturing method of the display device using the prior art technologies, the manufacturing method of this embodiment can reduce the raw material cost, the equipment cost and the process time and can lower the production cost. The manufacturing method of the display device having such a low production cost is particularly effective for a large scale display device having a substrate size of the fifth generation (1,000 x 1,200 mm²) or more.

A gate electrode 601a, a capacitance electrode 601b, a gate wiring 650a and a capacitance electrode 650b are formed on a substrate 600. A transparent substrate having a substrate size of 1,000 x 1,200 mm² and made of glass or plastic is used for the substrate 600. The gate electrode 601a, the capacitance electrode 601b, the gate wiring 650a and the capacitance electrode 650b are formed by the steps of serially forming aluminum (Al) containing neodymium (Nd), and molybdenum (Mo) on the entire surface of the substrate to form a conductor film, forming a resist mask on the conductor film and etching the conductor film by using the resist mask as the mask. The resist mask is formed by the steps of forming a resist film by use of a spin coat method and processing the resist film by photolithography. Besides aluminum (Al) containing neodymium (Nd), the material of the gate electrode 601a, the capacitance electrode 601b, the gate wiring 650a and the capacitance electrode 650b may use a conductor material such as chromium (Cr). A laminate film obtained by serially laminating titanium (Ti), Al and Ti may be used, too. Incidentally, the substrate 600 may have a size other than the size described above.

Besides the formation of the conductor film on the entire surface of the substrate described above, the gate electrode 601a, the capacitance electrode 601b, the gate wiring 650a and the capacitance electrode 650b may be formed by partially forming the conductor film at the atmospheric pressure by use of the apparatus shown in the second or third embodiment.

Fig. 20(A) is a top view of a part of the substrate on which the gate electrode 601a and the capacitance electrode 601b are formed. In Fig. 20(A), the gate electrode 601a and the gate wiring 650a are formed integrally with each other. The capacitance electrode 601b and the capacitance wiring 650b are formed integrally with each other, too.

Next, an insulating film 602 covering the gate electrode 601a, the capacitance electrode 601b, the gate wiring 650a and the capacitance electrode 650b is formed. An insulating film such as a silicon nitride film or a silicon oxide film or a laminate film of the silicon nitride film and the silicon oxide film, etc, is used for the insulating film 602. The portion above the gate electrode 601a of the insulating film 602 operates as a gate insulating film.

Next, a semiconductor film 603 is formed on the insulating film 602 (Fig. 18A)). The semiconductor film 603 is formed by depositing an amorphous silicon film, or the like, on the entire substrate. Incidentally, an impurity for imparting an N type or P type need not be added, in particular, to the semiconductor film 603.

Incidentally, as to the formation of the semiconductor film 603, a technology for partially forming the semiconductor film 603 at portions at which TFT must be formed at or near the atmospheric pressure by using the plasma treatment apparatus shown in the second embodiment may be employed, too, besides the formation of the film on the entire substrate described above.

Next, after an N type semiconductor film 604 is formed on the semiconductor film 603 (Fig. 18(B), Fig. 20(B)), a resist mask 605 is formed on the N type semiconductor film 604, and the N type semiconductor film 604 and the semiconductor film 603 are etched by using the resist mask 605 as the mask (Fig. 18(C), Fig. 20(C)). Here, the formation of the resist mask is carried out by using the liquid droplet jetting method such as the one shown in the first embodiment. In this way, the use amount of the resist solution and the number of process steps relating to photolithography can be drastically reduced. Etching is carried out at the atmospheric pressure or a pressure near the atmospheric pressure by using the apparatus shown in the second embodiment. Additionally, this embodiment uses an amorphous silicon film doped with phosphorous for the N type semiconductor film 604.

Next, a source wiring 608 and a wiring 609 obtained by laminating the N type semiconductor film 604 and the conductor film 606a or 606b are formed. Incidentally, the wiring 609 is disposed for connecting the TFT and the pixel electrodes. The formation method of the source wiring 608 and the wiring 609 will be hereinafter explained.

In this embodiment, a film prepared by serially laminating molybdenum (Mo), aluminum (Al) and molybdenum (Mo) is used for the conductor films 606a and 606b. Beyond the above, titanium (Ti), or the like, may be used besides Mo.

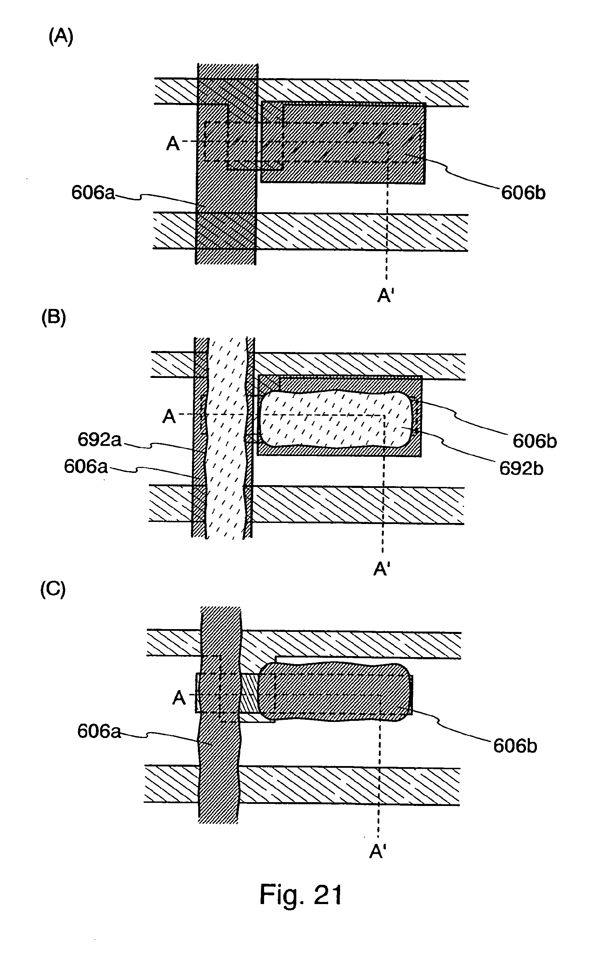

A plurality of conductor films 606a and 606b isolated in an island form is partially formed by the method shown in the third embodiment and by using the plasma treatment apparatus 690 (Fig. 18(E), Fig. 21(A)). Incidentally, the conductor film 606a isolated in the island form is so formed as to operate as the source wiring and the conductor film 606b is so formed as to operate as a wiring 609 for connecting the TFT and the pixel electrodes. Next, resist masks 692a and 692b are formed on the conductor films 606a and 606b and the conductor films 606a and 606b are etched by using the resist mask 692 as the mask. The formation of the resist mask is hereby carried out by using the liquid droplet jetting apparatus 691 shown in the first embodiment. Etching is partially carried out at or near the atmospheric pressure by using the apparatus shown in the second embodiment. Because the conductor films 606a and 606b are formed in this way by partial film formation, the use amount of the raw material for the film formation step of the conductor films 606a and 606b can be reduced. When the conductor films 606a and 606b partially formed are processed by using the resist masks 692a and 692b, a source wiring 608 and a wiring 609 each having a more precise shape can be formed (Fig. 18(E), Fig. 19(A), Fig. 21(B), Fig. 21(C)).

Next, the N type semiconductor film 604 is etched by using the conductor films 606a and 606b as the mask and the source and drain regions of the TFT are isolated.

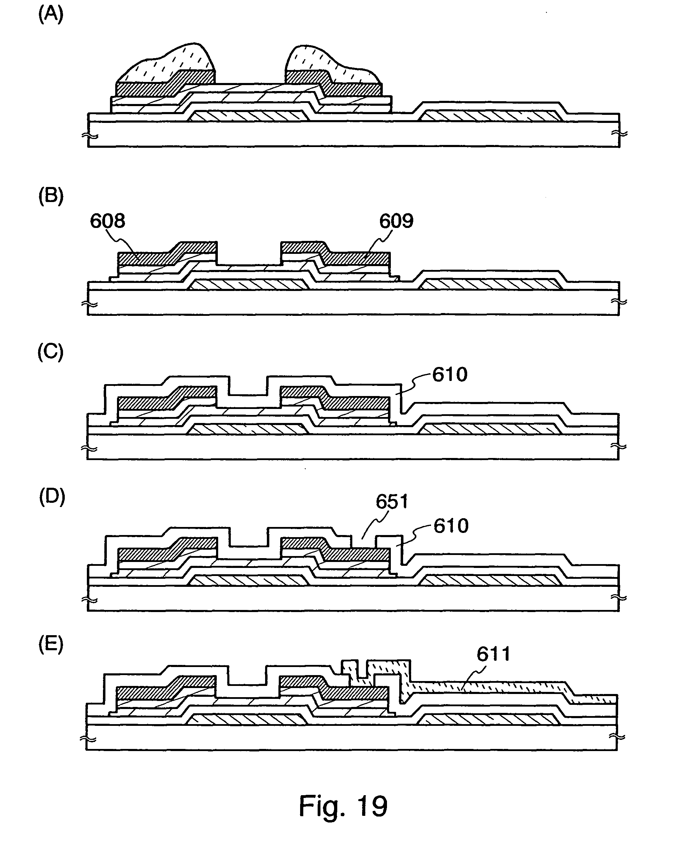

Incidentally, a part of the semiconductor film 603 is etched, too, during etching of the N type semiconductor film 604 (Fig. 19(B)).

Next, an insulating film 610 is formed over the source wiring 608 and the wiring 609 (Fig. 19(C)). A silicon nitride film or a silicon oxide film is used for the insulating film 610.

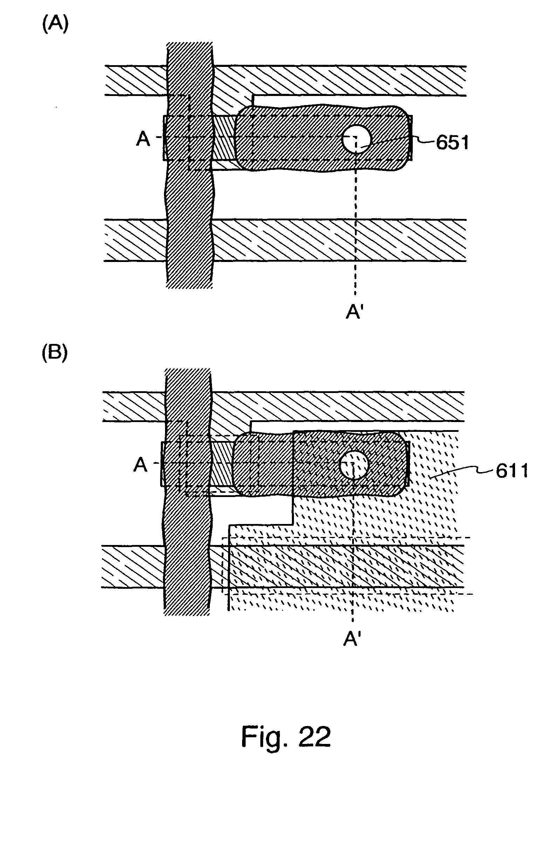

Next, a contact hole 651 penetrating through the insulating film 610 and reaching the wiring 609 is formed (Fig. 19(D), Fig. 22(A)). In this embodiment, the contact hole 651 is formed by the method shown in the fifth embodiment. Incidentally, this method is not restrictive and the method shown in the sixth embodiment may be used to form.

Next, a pixel electrode 611 is formed (Fig. 19(E), Fig. 22(B)). The pixel electrode is formed by the steps of forming a transparent conductor film such as ITO (Indium Tin Oxide), forming a resist mask in the transparent conductor film by using a spin coat method and further etching the transparent conductor film by using the resist mask as the mask.

A TFT array substrate on which the TFT for driving the pixel electrode, the capacitance and pixel electrodes are formed is formed in the manner described above. Incidentally, Fig. 18(A) to Fig. 19(E) correspond to sectional views of the portions indicated by broken line A - A' in Fig. 20(A) to Fig. 22(B), respectively.

A cell assembly step of the TFT array substrate fabricated as described above may be carried out in the same way as the method shown in the sixth embodiment and the description is omitted in this embodiment.

### (Embodiment 8)

The sixth and seventh embodiments use the resist mask that is formed by photo-lithographically processing the resist film formed by the spin coat method in the formation step of the gate electrodes 301a and 601a, the capacitance electrodes 301b and 601b, and so forth. However, this method is not restrictive and the resist mask that is partially formed on the conductor film may be formed by using the apparatus shown in the first embodiment. In this way, the use amount of the resist solution and the number of steps relating to photolithography can be drastically reduced.

To form the gate electrodes 301a and 601a and the capacitance electrodes 301b and 601b into a more precise shape, it is possible to partially form the resist film, to process the resist film into a desired shape by photolithography to acquire the resist mask and to etch the conductor film by using this resist mask. In this case, the use amount of the resist solution can be drastically reduced, too.

Other steps may be carried out by the same method as those shown in the sixth and seventh embodiments.

### (Embodiment 9)

The sixth, seventh and eighth embodiments use the resist mask obtained by the steps of forming the resist film using the spin coat method and processing the resist film by photolithography, in the formation step of the pixel electrode. However, this is not restrictive and it is possible to use a resist mask obtained by the steps of partially forming the resist film on the transparent conductor film by using the apparatus shown in the first embodiment, and using the resist film in the as-formed state. In this way, the use amount of the resist solution and the number of steps relating to photolithography can be drastically reduced.

It is further possible to form a resist film on the entire surface of the substrate by using the apparatus shown in the first embodiment and to process the resist film by photolithography to form the resist mask. In this case, the use amount of the resist solution can drastically be reduced in the case where the resist film is formed on the entire surface of the substrate in comparison with the spin coat method.

### (Embodiment 10)

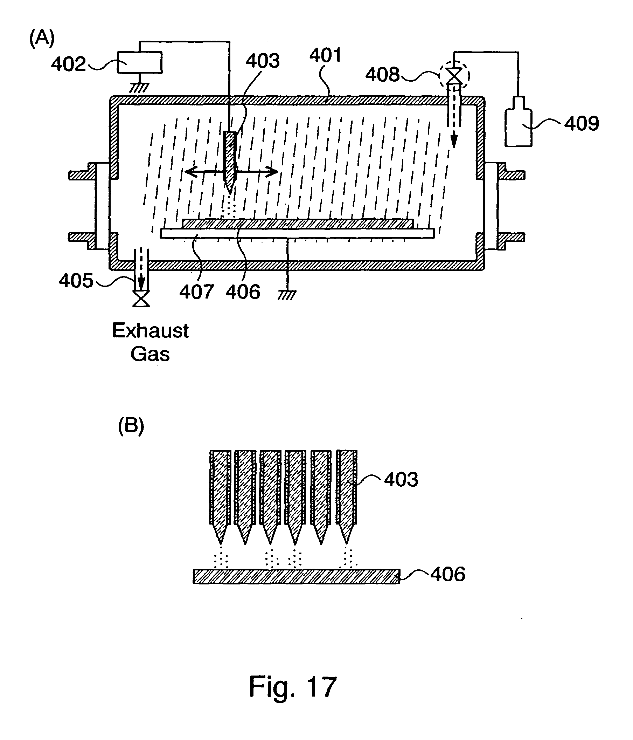

In this embodiment, a plasma treatment apparatus characterized in that a plasma treatment is carried out at or near the atmospheric pressure will be explained with reference to Fig. 17.

Fig. 17(A) is a sectional view of a treatment chamber 401 for conducting the plasma treatment at or near the atmospheric pressure (5 to 800 Torr). A needle-like electrode 403 connected to a power source 402 and a ground electrode 407 opposing the first electrode 403 are disposed inside the treatment chamber 401. A treated article 406 having a desired size such as a glass substrate and a plastic substrate is set onto the ground electrode 407. A reactive gas is supplied into the treatment chamber 401 from gas feed means 409 through a valve 408 and an exhaust gas is discharged from an exhaust port 405. The exhaust gas is passed through a filter and may be utilized again by removing dust admixed into the filter. Since the gas is re-utilized in this way, utilization efficiency of the gas can be improved. Heating means such as a lamp may be disposed inside the treatment chamber 401, whenever necessary, though it is not shown in the drawing.

When the reactive gas is supplied into the treatment chamber 401, the atmosphere inside the treatment chamber 401 is exchanged. When a high frequency voltage (50 kHz to 1 MHz, preferably 100 to 1,000 kHz) is supplied to the needle-like electrode 403 under this state, plasma is generated. A predetermined plasma treatment can be applied to the surface of the treated article 406 by the reactive gas containing chemically active excitation seeds such as ions and radicals generated by this plasma. Incidentally, the predetermined surface treatment is carried out while either one, or both, of the needle-like electrode 403 and the treated article 406 move relative to each other.

The invention using the plasma treatment apparatus operating at or near the atmospheric pressure does not require evacuation that is necessary for a pressure reduction apparatus, does not either require a complicated vacuum system and does not further require the time for evacuation and the release to the atmospheric pressure. Particularly when a large scale substrate is used, a chamber becomes inevitably large in scale and the processing time for bringing the inside of the chamber into the pressure reduction state is necessary. Therefore, the apparatus of the invention operating at or near the atmospheric pressure is effective and can reduce the production cost.

As shown in Fig. 17(B), a plurality of needle-like electrodes 403 may be arranged in a linear form. Partial and selective processing can be carried out by appropriately selecting a needle-like electrode 403 to which the voltage is applied among the plurality of electrodes 403. When a plurality of plasma treatment means arranged linearly in this way is used, it is advantageous in view of a tact time, and when a plurality of plasma treatment means are preferably arranged in the same length as the length of one side of the substrate, processing can be completed by a single scanning operation. Incidentally, the scanning direction is not particularly limited to a direction parallel to one side of the substrate and scanning may be carried out in an oblique direction.

### (Embodiment 11)

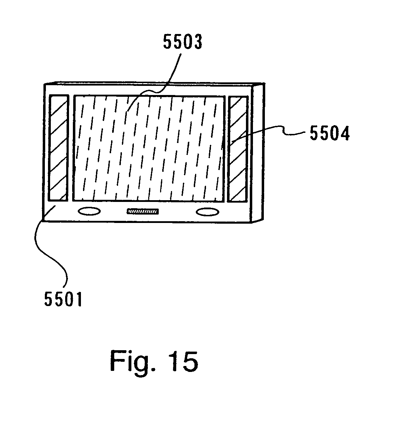

This embodiment explains an electronic appliance produced by applying the invention with reference to Fig. 15. Since the invention can produce a large-scale display device at an extremely low production cost, the invention can supply an electronic appliance having the display device mounted thereto at an extremely low cost though it is large in scale. The invention can be applied to not only the large-scale electronic appliance but also a compact electronic appliance such as a cellular telephone set that is produced by using a method that collectively forms a plurality of small TFT array substrates on a large glass substrate.

Fig. 15 shows a large liquid crystal television that includes a casing 5501, a display portion 5503 and a sound output portion 5504. The invention can be used for the display portion 5503 and can be applied to a display device having this.

## Claims

1. A manufacturing method of a display device **characterized by** including a step of forming a wiring by partially forming a conductor film over a substrate by use of plasma treatment means having an electrode for generating plasma at a pressure of 5 to 800 Torr.

2. A manufacturing method of a display device **characterized by** including a step of forming a wiring by partially forming a conductor film over a substrate by use of plasma treatment means having a plurality of electrodes for generating plasma at a pressure of 5 to 800 Torr.

3. A manufacturing method of a display device **characterized by** comprising steps of:
partially forming a conductor film over a substrate at a pressure of 5 to 800 Torr by use of first plasma treatment means;
forming a resist mask on the conductor film; and
partially etching the conductor film at a pressure of 5 to 800 Torr by use of second plasma treatment means with the resist mask as a mask, and forming a wiring.

4. A manufacturing method of a display device **characterized by** comprising steps of:
partially forming a conductor film over a substrate at a pressure of 5 to 800 Torr by use of first plasma treatment means having a plurality of electrodes;
forming a resist mask on the conductor film; and
partially etching the conductor film at a pressure of 5 to 800 Torr by use of second plasma treatment means with the resist mask as a mask and forming a wiring.

5. A manufacturing method of a display device **characterized by** comprising steps of:
partially forming a conductor film over a substrate at a pressure of 5 to 800 Torr by use of first plasma treatment means;
forming a resist mask on the conductor film; and
partially etching the conductor film at a pressure of 5 to 800 Torr by use of second plasma treatment means having a plurality of electrodes with the resist mask as a mask and forming a wiring.

6. The manufacturing method of the display device according to any of claims 1 to 5, wherein the substrate has a size of 1,000 x 1,200 mm² or more.

7. The manufacturing method of the display device according to any of claims 1 to 5, wherein the plasma treatment means scans the substrate in one direction.

8. The manufacturing method of the display device according to any of claims 1 to 5, wherein the plasma treatment means alternately scans the substrate in a row direction and in a column direction.

9. The manufacturing method of the display device according to any of claims 1 to 5, wherein the resist mask is formed by use of liquid droplet jetting means.

10. A manufacturing method of a display device **characterized by** comprising steps of:
forming an insulating film covering a thin film transistor; and
partially blowing a reactive gas to the insulating film and forming an open portion.

11. A manufacturing method of a display device **characterized by** comprising steps of:
forming an insulating film covering a thin film transistor;
forming a resist mask on the insulating film; and
etching the insulating film by using the resist mask as a mask;
wherein the resist mask is formed by photo-lithographically processing a resist film partially formed by liquid droplet jetting means; and
wherein etching of the insulating film includes a step of conducting etching by use of plasma treatment means at a pressure of 5 to 800 Torr.
